(19) Europäisches Patentamt
European Patent Office
Office européen des brevets

(11) **EP 2 843 433 A1**

(12) **EUROPEAN PATENT APPLICATION**
published in accordance with Art. 153(4) EPC

(43) Date of publication:
**04.03.2015 Bulletin 2015/10**

(51) Int Cl.:
***G01R 33/02*** *(2006.01)*

(21) Application number: **12888453.3**

(86) International application number:
**PCT/KR2012/009720**

(22) Date of filing: **16.11.2012**

(87) International publication number:
**WO 2014/077431 (22.05.2014 Gazette 2014/21)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(71) Applicant: **Korea Basic Science Institute
Daejeon 305-806 (KR)**



(72) Inventors:
• **PARK, Seung Young
  Daejeon 302-777 (KR)**
• **KIM, Sang Il
  Busan 601-832 (KR)**

(74) Representative: **Cabinet Plasseraud
52, rue de la Victoire
75440 Paris Cedex 09 (FR)**

(54) **SPIN TORQUE-TYPE MAGNETIC SENSOR**

(57) The present invention is directed to a magnetic sensor using a spin transfer torque device, including a spin transfer torque device configured such that the magnetization direction thereof is varied by current, a bipolar pulse source configured to apply bipolar pulses to the spin transfer torque device in order to control the coercive field and sensitivity of the spin transfer torque device, and a signal processing unit configured to calculate magnetic susceptibility or magnetic resistance by counting the parallel (P) or anti-parallel (AP) states of the spin transfer torque device in response to the applied bipolar pulses.

## FIG. 6

signal processing unit

EP 2 843 433 A1

## Description

**Technical Field**

The present invention relates to a magnetic sensor using spin transfer torque devices and, more particularly, to a magnetic sensor that can respond linearly to the strength of a magnetic field by applying bipolar pulses to a spin transfer torque device and thereby controlling a coercive field.

Furthermore, the present invention relates to a magnetic sensor that can shift a dynamic range by a magnetic field corresponding to an offset bias by applying the offset bias together with bipolar pulses and that can control sensitivity by adjusting the amplitude and strength of bipolar pulses.

**Background Art**

A magnetic sensor measures the magnitude or direction of a magnetic field based on a phenomenon in which the magnetic susceptibility or magnetic resistance of a material varies in response to a magnetic field. Generally used magnetic sensors include Hall magnetic sensors using the Hall effect, giant magnetoresistance (GMR) sensors using the GMR phenomenon, tunneling magnetoresistance (TMR) sensors, fluxgate magnetic sensors, superconducting quantum interference devices (SQUID) sensors, etc. The uses of these magnetic sensors are determined depending on their characteristics, such as a dynamic range or sensitivity. GMR sensors and TMR sensors can detect a 100 Gauss-level magnetic field with high sensitivity and, additionally, can be fabricated in a very small size, such as a micro-scale size, so that they are chiefly used to read information from hard disk drives (HDDs). Meanwhile, fluxgate magnetic sensors can be fabricated as sensors of various sizes ranging from large-sized sensors to several hundred micrometer-level small-sized sensors and, additionally, can detect a 10 Gauss-level magnetic field with high sensitivity, so that they are used for the purposes of geomagnetic sensors or electronic compasses.

GMR sensors measure a magnetic field by measuring a variation in resistance using a phenomenon in which in a magnetic multilayer film structure composed of a "magnetic layer/a nonmagnetic layer/a magnetic layer," a large amount of current flows because of low electric resistance when the magnetization directions of the two magnetic layers are made parallel (hereinafter this state is referred to as the "P" state) by an external magnetic field and a small amount of current flows because of high electric resistance when the magnetization directions of the two magnetic layers are made anti-parallel (hereinafter this state is referred to as the "AP" state).

In contrast to the fact that a conventional GMR sensor is sensitive to a magnetic field, the direction of magnetization may be varied by applying a current (a spin current). This is related to spin transfer torque (STT). The spin of each conduction electron that forms a current is polarized while the current is passing through a magnetic layer. In this case, since spin angular momentum is always conserved, force corresponding to a variation in the spin angular momentum of the conduction electron is transferred to the spin of a magnetic layer, and thus torque that changes the magnetization direction of the magnetic layer to a direction opposite the spin polarization direction of the conduction electron acts on magnetization. STT is a phenomenon in which the direction of magnetization is varied by directly interacting with a current other than a magnetic field. Accordingly, this enables the direction of magnetization to be varied by applying only a current without requiring a magnetic field, thereby being used as memory, a sensor, an oscillator, and the like.

A spin transfer torque device using STT has a high variation in magnetic resistance above 100% in contrast to the fact that variations in the magnetic resistance of GMR and TMR devices are 10% and 50%, respectively, and thus the sensitivity of the spin transfer torque device is very high. Accordingly, a higher signal-to-noise ratio (SNR) can be obtained in magnetic field detection application bands around 100 Gauss. However, in spite of such higher sensitivity, the spin transfer torque device using STT is problematic in that a measurement range (a dynamic range) is very narrow (about 1 Gauss) and in that there is the dispersion of a switching magnetic field in connection with a manufacturing process and thermal stability. Furthermore, a coercive field Hc attributable to the hysteresis of a ferromagnetic layer is present, and thus linearity is limited. In order to mitigate the hysteresis characteristic of the magnetoresistance sensor so that it meets that of a linear magnetic sensor, an improvement in the characteristic of the material itself or an additional circuitry function for compensating for a hysteresis characteristic is required.

With regard to a conventional technology for controlling the coercive field and dynamic range of a magnetoresistance sensor, Korean Patent No. 0820079 discloses a technology for mitigating the hysteresis characteristic of a spin device by applying an AC or DC control magnetic field to the outside of a spin device through an exciting wire. Since the magnetic field is applied from the outside, the magnetoresistance sensor requires the additional exciting wire and magnetic field control, and thus the structure thereof becomes complicated. Furthermore, the consumption of driving power required to eliminate a coercive field is high, thus resulting in the radiation of heat.

**Disclosure**

**Technical Problem**

The present invention is intended to provide a magnetic sensor using a spin transfer torque device to which technology for applying bipolar pulses and an offset bias to a spin transfer torque device in order to compensate for the hysteresis characteristic of the magnetic sensor, thereby eliminating the coercive field of the magnetic sensor, improving sensitivity, and also controlling a dynamic range and the offset of the dynamic range.

**Technical Solution**

In order to solve the above technical problem, the present invention provides a magnetic sensor using a spin transfer torque device, including a spin transfer torque device configured such that the magnetization direction thereof is varied by applied direct current (DC) power; a bipolar pulse source configured to apply bipolar pulses to the spin transfer torque device in order to control the coercive field and sensitivity of the spin transfer torque device; and a signal processing unit configured to calculate magnetic susceptibility or magnetic resistance by counting the P or AP states of the spin transfer torque device in response to the applied bipolar pulses.

In a preferred embodiment of the present invention, the signal processing unit includes a counter configured to count the P or AP states of the spin transfer torque device; and a computation unit configured to perform computation on values counted by the counter.

In a preferred embodiment of the present invention, a low frequency band-pass filter configured to eliminate high frequency components attributable to the bipolar pulses is added upstream of the signal processing unit.

In a preferred embodiment of the present invention, the magnetic sensor further includes a bias unit configured to apply an offset bias to the spin transfer torque device in order to control the location of the dynamic range of the spin transfer torque device.

In a preferred embodiment of the present invention, the magnetic sensor further includes a resistor unit of a resistance characteristic connected in series to the spin transfer torque device, and the output level of the magnetic sensor is adjusted by controlling the resistance value of the resistor unit.

In a preferred embodiment of the present invention, a second spin transfer torque device is connected in series instead of the resistor unit, and then the output level of the magnetic sensor is adjusted.

In another embodiment of the present invention, there is a spin transfer torque-type magnetic sensor integrated circuit chip, including a spin transfer torque device configured such that the magnetization direction thereof is varied by applied DC power; an offset control unit configured to control the offset of the output of the spin transfer torque device; and electrode pads configured to receive and output signals from and to the spin transfer torque device; and the spin transfer torque device, the offset control unit, and the electrode pads are integrated into a single substrate.

In a preferred embodiment of the present invention, the spin transfer torque-type magnetic sensor integrated circuit chip of claim further includes a coercive field/dynamic range control unit configured to control the coercive field and sensitivity of the spin transfer torque device; and a signal processing unit configured to calculate magnetic susceptibility or magnetic resistance by counting the P or AP states of the spin transfer torque device in response to the applied bipolar pulses.

In a preferred embodiment of the present invention, the spin transfer torque-type magnetic sensor integrated circuit chip further includes an analog-to-digital converter (ADC) configured to convert the analog signals of the sensor into digital signals.

**Advantageous Effects**

The advantages of the present invention are as follows:

First, the coercive field of a magnetic resistance device can be controlled and also hysteresis can be eliminated by controlling the amplitude of a high-frequency current waveform.

Second, the polarity and strength of even a weak magnetic field of several oersteds emitted from a measurement target can be determined because there is no hysteresis.

Third, a dynamic range may be freely shifted by controlling an offset bias or additionally applying an external magnetic field.

Fourth, the magnetic sensor of the present invention is connected in series to an active variable resistor or a spin transfer torque device using a resistor or a transistor, and then an output voltage region can be controlled.

Fifth, a magnetic field dynamic range can be extended and searched because a tens-of-oersted region can be scanned using a sweep method that varies an offset bias.

Sixth, the magnetic sensor of the present invention can be used in a variety of fields, such as the detection of nanoparticles, nondestructive tests, metallic detection, geomagnetic detection, etc. because a tens-of-oersted wide region can be finely divided at a resolution equal to or lower than one oersted using the fifth advantage.

Seventh, the commercial market in a corresponding field can be shared because the magnetic sensor of the present invention can compare with conventional magnetic field detection devices, such as fluxgates and Hall sensors thanks to the sixth advantage, and the magnetic sensor of the present invention can be applied to micro-devices (micromachines) because it can be fabricated in a size smaller than those of the above devices.

Eighth, an exciting wire may be additionally provided. In this case, the phase of a current wave input to the exciting wire is made different from the phase output from the magnetic sensor by varying the magnitude of a coercive field, and thus the magnetic sensor may be used as a phase modulation device. That is, when a coercive field is weak, output resistance attributable to input current waves input to the exciting wire immediately varies, and thus a phase delay is small. In contrast, when the coercive field is strong, a delay is increased by the time it takes for the amplitude of the current waves to increase to a value that is sufficient to enable magnetization switching and thus an electric signal is output from the magnetic sensor.

**Description of Drawings**

FIG. 1 illustrates the differences between switching phase diagrams that appear when unipolar and bipolar pulses are applied to a spin transfer torque device;

FIG. 2 illustrates bipolar pulses (FIG. 2(a)) and the relationships between magnetic resistance and the strength and direction of magnetic fields (FIGS. 2(b), 2(c), and 2(d)) as functions of time, in a spin transfer torque device;

FIG. 3 illustrates variations in a magnetic field depending on bipolar pulse voltages using bias voltage as a variable, that is, experimental results;

FIG. 4 illustrates that a region in which a magnetic resistance curve appears varies depending on the direction of an externally applied magnetic field;

FIG. 5 illustrates a shift of an operation region when a DC magnetic field $H_{bias}$ or voltage is mixed in the state in which an AC magnetic field or current is applied, that is, a coercive field is eliminated;

FIG. 6 illustrates an example of a system that is capable of performing a magnetic field detection function by applying bipolar pulses;

FIG. 7 illustrates examples of signal processing depending on the direction and strength of a magnetic field according to an embodiment of the present invention;

FIG. 8 illustrates an embodiment of the present invention in which a bias unit and a low frequency band-pass filter have been added;

FIG. 9 illustrates a shift of a dynamic range depending on the DC sign and strength of a bias;

FIG. 10 illustrates an example of a circuit capable of controlling the output voltage level of a magnetic field detection system using a spin transfer torque device;

FIG. 11 illustrates an embodiment according to the present invention;

FIG. 12 illustrates an example of a magnetic field sensor integrated circuit using a spin transfer torque device;

FIG. 13 illustrates an example of a disposable magnetic sensor module according to the present invention; and

FIG. 14 is a conceptual diagram of a disposable magnetic sensor module mounted in a portable reader, which is an embodiment of the present invention.

**Best Mode**

A magnetic sensor using a spin transfer torque device according to the present invention includes a spin transfer torque device configured such that the magnetization direction thereof is varied by applying a current, a bipolar pulse source configured to apply bipolar pulses to the spin transfer torque device in order to control the coercive field and sensitivity of the spin transfer torque device, and a signal processing unit configured to calculate magnetic susceptibility or magnetic resistance by counting the P or AP states of the spin transfer torque device in response to the applied bipolar pulses.

**Mode for Invention**

Details that are used to practice the present invention will be described with reference to the accompanying drawings. Since the illustrated drawings illustrate only essential principal elements and omit auxiliary elements for the purpose of clarity of the present invention, the present invention should not be interpreted only based on the drawings.

A spin transfer torque device that is used in the present invention uses a magnetic multilayer film structure generally composed of a "magnetic layer/a nonmagnetic layer/a magnetic layer." The magnetic layer is made of a ferromagnetic material in which the spin of electrons and magnetic moment attributable to orbital angular momentum influence each other. In the case of a ferromagnetic material, magnetization increases and then a magnetic saturation state is reached when a magnetic field is increased, remanent magnetization occurs without a magnetic field when the magnetic field is decreased, and the same phenomenon occurs in the opposite direction when a magnetic field is applied in the opposite direction, thereby causing a magnetization curve to assume a closed hysteresis loop. Accordingly, magnetization nonlinearly occurs in response to an applied magnetic field, and remanent magnetization is generated by spontaneous magnetization. A magnetic field in the opposite direction that is required to eliminate such remanent magnetization is referred to as a coercive field (Hc).

In conventional technology, a coercive field is cancelled out by applying a magnetic field from the outside in order to control the coercive field and dynamic range of a magnetic sensor. In contrast, the present invention proposes technology that can control a coercive field and sensitivity in such a way as to apply bipolar pulses directly to a spin transfer torque device using the STT phenomenon and that can shift a dynamic range in such a way as to apply an offset bias thereto.

In addition, the present invention proposes technology that can control sensitivity in such a way as to apply a bipolar pulse having amplitude higher than that of a minimum voltage or current (critical voltage or current) that enables magnetization switching to be achieved using only a voltage or a current.

## 1. Method of Controlling Coercive Field

In a spin transfer torque device, magnetic switching is generated by using only a magnetic field without requiring a bias current or voltage, as in a conventional spin device. Another characteristic of a spin transfer torque device is that magnetic switching is generated by using only a current or voltage passing through the spin transfer torque device without requiring a magnetic field. Accordingly, a spin transfer torque device has one additional variable related to the generation of magnetic switching compared to a conventional spin device.

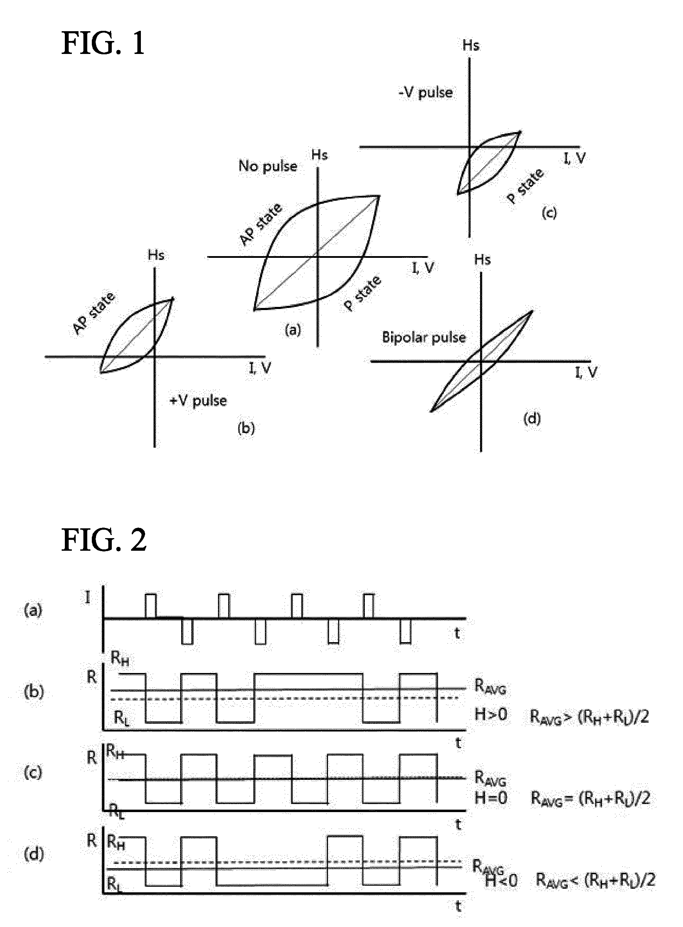

FIG. 1 is a switching state diagram of a spin transfer torque device illustrating magnetic states with voltage or current plotted on the horizontal axis and the switching magnetic field plotted on the vertical axis. FIG. 1(a) is a typical state diagram. In the switching state diagram, two curves are present. One curve is a curve indicative of a boundary at which the state shifts from a P state to an AP state, and the other curve is a curve indicative of a boundary at which the state shifts from an AP state to a P state. For example, for convenience, a right line passing through the fourth quadrant is referred to as a boundary (AP → P) at which the state shifts from an AP state to a P state, and a left line passing through the second quadrant is referred to as a boundary (P → AP) at which the state shifts from a P state to a AP state.

FIG. 1(b) illustrates that if a unipolar pulse having a positive value is applied, the right line passing through the fourth quadrant moves in the direction of an origin because it is easy to enter the P state, and FIG. 1(c) illustrates that if unipolar pulses having a negative value are applied, the left line passing through the second quadrant moves in the direction of the origin because it is easy to enter the AP state. If bipolar pulses alternating between positive and negative signs are applied, boundaries existing in the fourth and second quadrants converge into a diagonal line that traverses the first and third quadrants. A minimum voltage or current that enables magnetization switching by using only voltage or current is referred to as a critical voltage or current. When the amplitude of bipolar pulses is higher than that of the critical voltage or current, the AP and P states alternately appear. If averages are taken for a sufficient period of time, resistance of a state between the AP and P states appears. Furthermore, the AP or P state sensitively appears in response to a small variation of several oersteds in magnetic field. Furthermore, the effect in which a coercive field disappears is achieved.

The magnetic susceptibility attributable to bipolar pulses applied to the spin transfer torque device may be replaced with magnetic resistance, the relationship of which is illustrated in FIG. 2. FIG. 2(a) illustrates a bipolar pulse train. If the magnetic resistance in a state that is saturated with a positive magnetic field (H>0) is $R_H$ and the magnetic resistance in a state that is saturated with a negative magnetic field (H<0) is $R_L$, FIG. 2(b) illustrates that if the positive magnetic field, that is, the number of positive pulses, is large, the average magnetic resistance $R_{avg}$ is higher than the average value $R_{avg}$ ($R_H + R_L/2$) of $R_H$ and $R_L$, FIG. 2(c) illustrates that if the numbers of positive and negative pulses are the same, the average magnetic resistance $R_{avg}$ is the same as the average value, and FIG. 2(d) illustrates that if the negative magnetic field, that is, the number of negative pulses, is large, the average magnetic resistance $R_{avg}$ is lower than average value of $R_H$ and $R_L$.

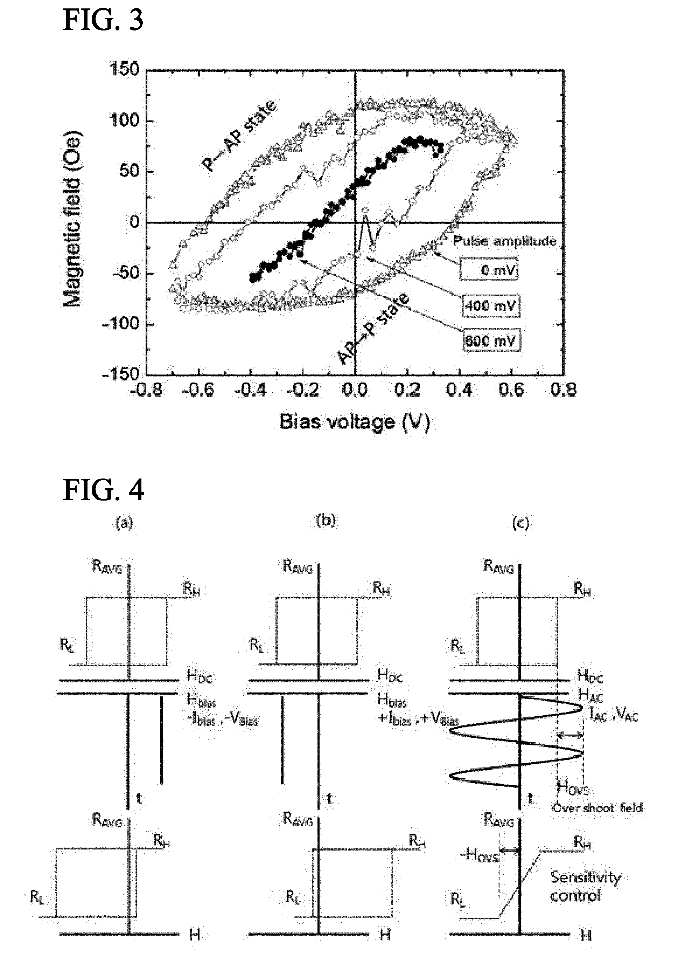

FIG. 3 illustrates a switching state diagram when a bipolar pulse is applied to a spin torque device. FIG. 3 illustrates experimental results in which DC bias voltage has been added as a variable and two variables have been simultaneously applied. It can be seen that when the amplitude of the bipolar pulse reaches that of the critical current or voltage, the coercive field is eliminated and the dynamic range shifts along a DC bias voltage axis (an x-axis).

## 2. Method of Controlling Sensitivity

If the coercive field is cancelled out by applying bipolar pulses to a spin transfer torque device, the shift between the P state and the AP state is rapidly performed. Accordingly, the problem occurs that the magnetic resistance becomes highly sensitive because the shift region between the low resistance state $R_L$ and the high resistance state $R_H$ is narrow, and thus only magnetic fields in a limited and narrow range are detected.

FIG. 4 illustrates a method of extending a dynamic range according to the present invention, which is a method of applying pulses having an excessive amplitude higher than that of the critical voltage or current that is required for switching (overshoot pulses). Although this function is implemented in a conventional spin device by applying magnetic field pulses $H_{AC}$, it may be possible to control sensitivity in the spin transfer torque device according to the present invention by applying not only magnetic field pulses but also voltage $V_{AC}$ or current pulses $I_{AC}$ passing through a specimen. As described above, in the spin transfer torque device, magnetization switching may be achieved using only the current and the magnetic field. If bipolar current pulses having an amplitude larger than the critical value are applied, magnetization switching is completed by the current rather than the magnetic field. This means that magnetization switching becomes insensitive to the magnetic field. Instead, the range in which the magnetic field can be detected is increased by the magnetic field corresponding to the amplitude of the pulses that is above the critical current.

It can be seen that if an AC magnetic field is applied while the sign of the magnetic field or current (or voltage) is changing over time at very high speed, the result can be obtained (FIG. 4(c)) in which FIG. 4(a) and FIG. 4(b) have been mixed with each other and the average thereof has been taken. Furthermore, it can be also seen that when the AC magnetic field or current having an amplitude equal to or larger than Hc (or Ic (an applied current value that generates the magnetic field Hc)) is applied, the slope of the sensitivity is decreased, and the dynamic range in which the magnetic field can be detected is increased, thereby controlling sensitivity, as illustrated in the lower diagram of FIG. 4(c).

## 3. Method of Controlling Dynamic Range Offset

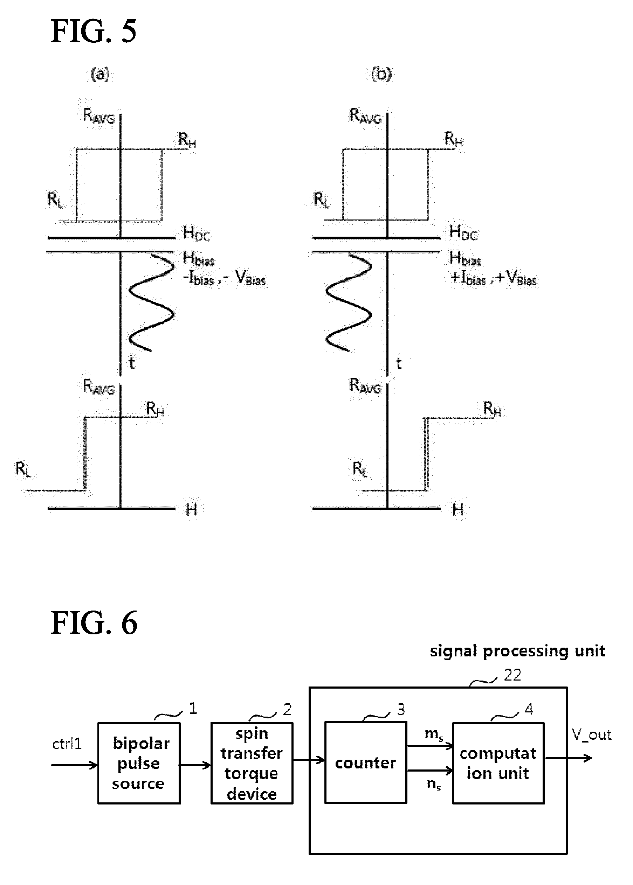

A method of shifting a dynamic range sensitive to a magnetic field in the magnetic sensor using a spin transfer torque device is to apply an additionally offset bias (a DC magnetic field or voltage (current)) while applying bipolar pulses. FIG. 5(a) ("of FIGS. 5(a) and 5(b)") illustrates a case of applying bipolar pulses while applying a positive (or negative) offset bias magnetic field (voltage (current)), in which case a dynamic range is shifted to a negative magnetic field region by the positive offset magnetic field. FIG. 5(b) illustrates a case of applying bipolar pulses while applying a negative (positive) offset bias magnetic field (voltage (current)), in which case the dynamic range is shifted to the positive magnetic field region by the negative offset magnetic field. The dynamic range may be shifted or selected by applying bipolar pulses while varying the offset bias at specific intervals based on the above-described principle.

## 4. Embodiment 1

A method of controlling a coercive field according to the present invention is illustrated in FIG. 6. The magnetic sensor illustrated in FIG. 6 includes a bipolar pulse source 1, a spin transfer torque device 2, and a signal processing unit 22 including a counter 3 and a computation unit 4.

The bipolar pulse source 1 applies pulses having a positive/negative amplitude directly to the spin transfer torque device 2 in order to cancel out the coercive field of the spin transfer torque device 2, and alternately applies positive/negative pulses. In this case, the shorter the period of the pulses is, the more desirable it is for the linearization of the magnetic sensor. The waveform of the bipolar pulse source 1 may correspond to bipolar sine waves or triangular waves apart from bipolar square waves illustrated in FIG. 2(a). Of the three bipolar waveform examples, bipolar square wave pulses have the lowest power consumption.

Although the spin transfer torque device 2 generally has a multilayer film structure composed of a fixed magnetic layer/a nonmagnetic layer/a free magnetic layer, the spin transfer torque device 2 is not limited thereto, but may be composed of a single magnetic layer. The spin transfer torque device 2 may be implemented as a nanocontact or a nanopillar. If necessary, the spin transfer torque device 2 may be implemented as an array in which unit spin transfer torque devices are connected in series or by a magnetic sensor.

The signal processing unit 22 calculates magnetic susceptibility or the number of times that magnetic resistance has been saturated by counting the parallel or AP states of the spin transfer torque device 2 based on applied bipolar pulses. The signal processing unit 22 may include the counter 3 and the computation unit 4.

The counter 3 counts the number of times per unit time that the spin transfer torque device 2 is in the AP state and in the P state when bipolar pulses are applied. The magnetic resistance of the spin transfer torque device 2 decreases until the magnetization direction of the fixed magnetic layer and the magnetization direction of the free magnetic layer have entered a P state. In contrast, when the magnetization direction of the free magnetic layer and the magnetization direction of the fixed magnetic layer have entered an AP state, the magnetic resistance value of the spin transfer torque device 2 increases.

The computation unit 4 calculates the average value using the dwell time of each pulse, a pulse period $\tau_c$, and the numbers m and n of P and AP states that have been counted by the counter 3, as expressed by the following Equation 1:

$$n\tau_p + m\tau_{ap} = (n + m)\tau_c \qquad\qquad (1)$$

where $\tau_p$ and $\tau_{ap}$ are the dwell time in the P state and the dwell time in the AP state, respectively.

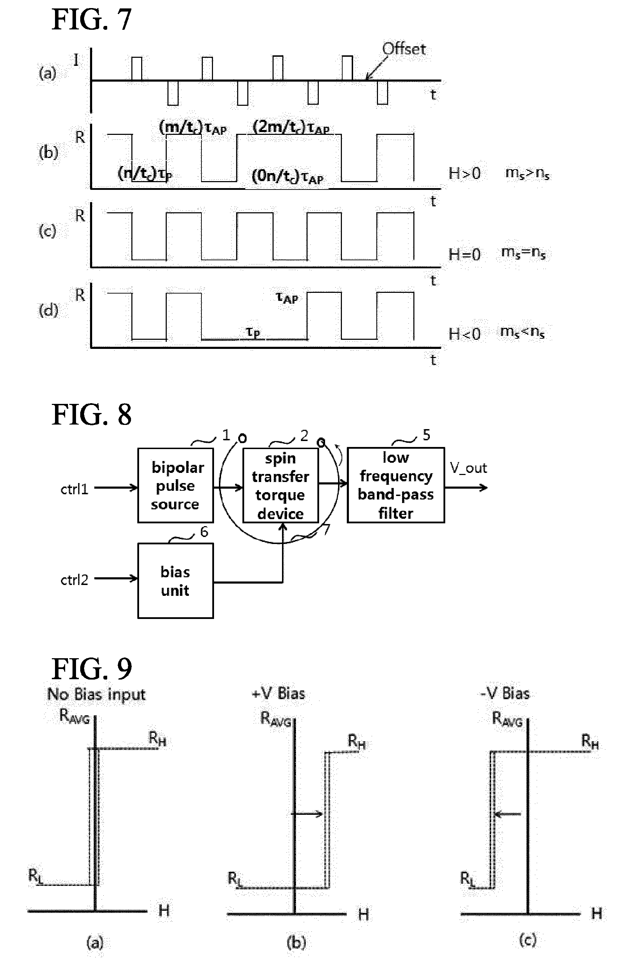

FIG. 7 illustrates computation processes as examples. In the case of FIG. 7(b) in which the positive magnetic field has been applied, the number of positive pulses is large, so that the number m of AP states is large and the average resistance is high. In the case of FIG. 7(c), the number m of AP states is the same as the number n of P states, so that the average resistance is intermediate. In the case of FIG. 7(d), the number of negative pulses is large (H<0), so that the number n of P states is large and the average resistance is lower than the intermediate value.

The numbers of AP states and P states are counted by circuits, such as flip-flops, inside the counter 3. To eliminate bipolar pulses, such as high frequency components, a low frequency band-pass filter may be installed upstream of the counter 4.

In embodiment 1, excessive pulses higher than the critical voltage (current) may be applied to control sensitivity, and a resistor network or an attenuator may be added to control the resistance variation rate.

## 5. Embodiment 2

A method of controlling a dynamic range offset according to the present invention is illustrated in FIG. 8. In the magnetic sensor illustrated in FIG. 8, a bias unit 6 capable of applying an offset bias is added to embodiment 1. In the present invention, although the offset of the dynamic range can be controlled by only the offset bias of voltage (current), an exciting wire 7 may be added to extend offset control to a wider region. Furthermore, it may be possible to replace the signal processing unit 22 of FIG. 6 with a low frequency band-pass filter 5. The low frequency band-pass filter performs the function of eliminating high-frequency noise attributable to bipolar pulses and the smoothing function of filtering variations in magnetic resistance value.

FIG. 9 illustrates an embodiment of the role of an offset bias. When an offset bias is not applied to voltage, a magnetic field proximate to 0 can be detected. When a positive (negative) offset bias is applied, as illustrated in FIG. 1, an effect in which a negative (positive) magnetic field is applied is achieved. Accordingly, the dynamic range is shifted to the region of the positive (negative) magnetic field by the strength of the negative (positive) magnetic field. A dynamic range may be placed at a desired location by applying bipolar pulses while varying an offset bias using the above principle.

In this embodiment 2, to control sensitivity, excessive pulses, equivalent to or above the critical current (voltage) or magnetic field, that enable magnetization may be applied, and a resistor network or an attenuator may be added to thereby adjust a variation rate in resistance.

## 6. Embodiment 3

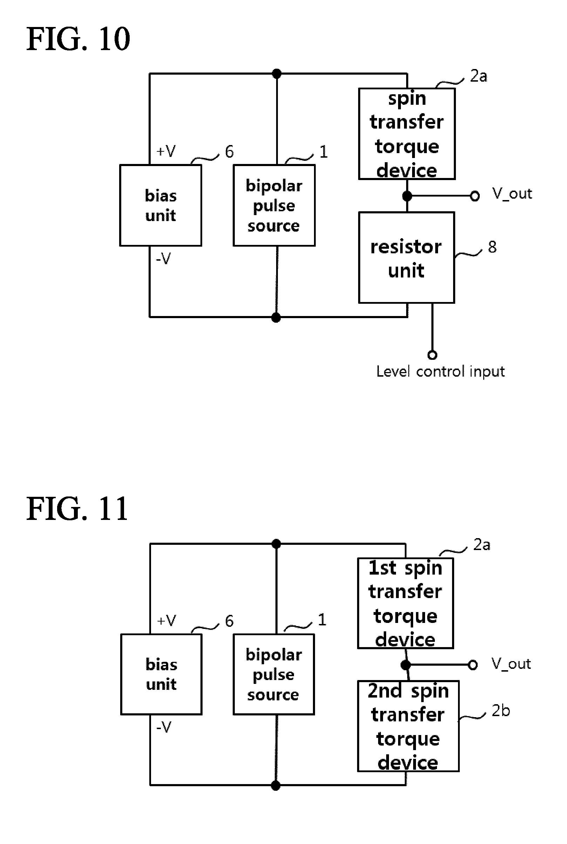

A method of controlling an output level according to the present invention is illustrated in FIG. 10. A magnetic sensor illustrated in FIG. 10 illustrates that a resistor unit (a resistor network or an attenuator) 8, the resistance level of which is variable, is added in series to a spin transfer torque device 2a. When the magnitude of the resistance is adjusted, the level of an output signal Vout may be determined using the voltage divider rule.

FIG. 11 illustrates an embodiment in which a spin transfer torque device 2b, instead of the resistor unit 8, has been added in series. The additional spin transfer torque device may be connected in series or parallel, and may vary the level of the output voltage depending on the method of connection. As an example, when the detection direction of a magnetic field of the spin transfer torque device 2b is opposite that of the spin transfer torque device 2a, a push-pull function may be performed.

## 7. Embodiment 4

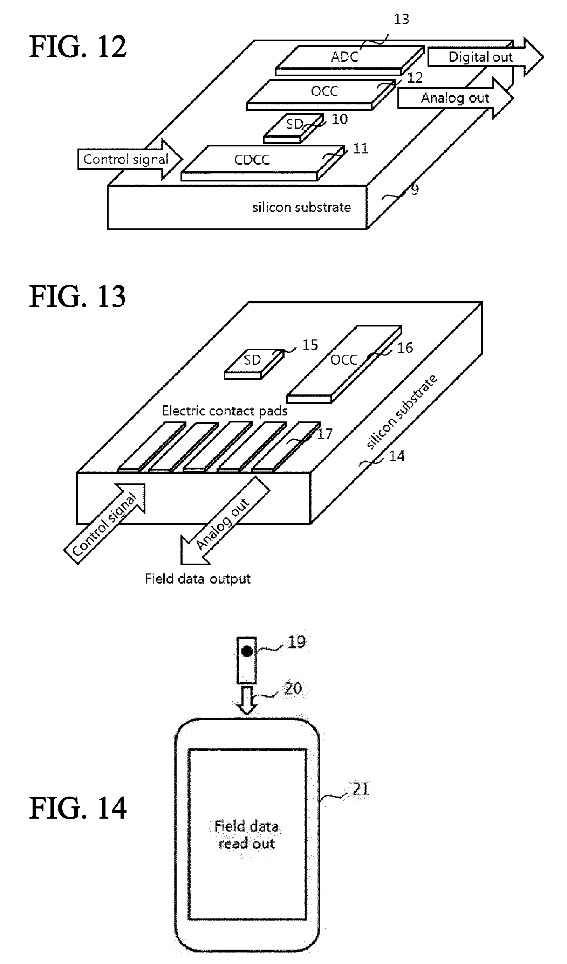

FIG. 12 illustrates an embodiment in which a magnetic sensor according to the present invention is integrated into a chip. The magnetic sensor according to the present invention includes a silicon substrate 9, a magnetic sensor using a spin transfer torque device 10, a coercive field/dynamic range control unit 11, an offset control unit 12, and an analog digital converter 13. Since the spin transfer torque device is compatible in terms of a silicon CMOS process, it is advantageous in that it allows for a reduction in size and integration into an integrated circuit.

The coercive field/dynamic range control unit 11 outputs control signals ctrl1 and ctrl2 operable to control the bipolar pulse source 1 and the bias unit 6 to the magnetic sensor using a spin transfer torque device 10. The offset control unit 12 controls the offset of the magnetic sensor using a spin transfer torque device 10. The analog digital converter 13 converts the analog output signals of the magnetic sensor 10 into digital signals. Magnetic field information may be selectively output in a digital or analog form.

FIG. 13 illustrates an embodiment in which a disposable magnetic sensor using a spin transfer torque device, which enables the structure of a sensor module to be simplified, thus reducing manufacturing cost, by outputting only analog signals if a host device is provided with a Digital to Analog Converter (DAC), has been integrated into a substrate 14. The disposable integrated circuit chip is made disposable by integrating only a magnetic sensor 15 using a spin transfer torque device and an offset control unit 16 into the substrate 14 and thus reducing manufacturing cost.

### 8. Embodiment 5

FIG. 14 illustrates an application to which a disposable magnetic sensor according to the present invention has been applied.

A disposable magnetic sensor 19 is connected to a mobile communication terminal 21 through the port 20 of the mobile communication terminal, and information detected by the disposable magnetic sensor 19 is read through the mobile communication terminal 21. For example, the disposable magnetic sensor 19 may be a sensor that detects information about the DNA of the human body that adheres to nanoparticles. The nanoparticle is a magnetic nanoparticle that can be magnetized, and, if a DNA probe is attached to the disposable magnetic sensor 19, the nanoparticles reach and adhere to the disposable magnetic sensor 19. In this case, it may be possible for the disposable magnetic sensor 19 to sensitively respond to a magnetic field generated around the nanoparticles and to count the number of nanoparticles to which a desired DNA adheres.

Furthermore, the magnetic sensor using a spin transfer torque device of the present invention is easy to be applied to nondestructive test sensors for detecting micro-cracks, medical nanoparticle sensors and future micro-robot applications. In particular, the manufacturing cost of the magnetic sensor using a spin transfer torque device of the present invention is low, and is thus easily used for the development of diagnostic kits. The magnetic sensor using a spin transfer torque device of the present invention can be applied to electronic compasses for mobile devices because it has a very small size and can ensure a high sensitivity characteristic, thereby providing a possibility for high marketability.

Although the present invention has been described with reference to embodiments, it will be apparent to those skilled in the art that various modifications and variations may be made to the present invention without departing from the spirit and scope of the present invention that have been described in the following claims.

### Industrial Applicability

The magnetic sensor using a spin transfer torque device according to the present invention may be applied to nondestructive test sensors for detecting micro-cracks, medical nanoparticle sensors, gear tooth sensors for small-sized high-precision machinery parts, and future micro-robot applications.

Furthermore, the magnetic sensor using a spin transfer torque device is easy to be used for the development of transparent sensors because it has a very small size.

In particular, the magnetic sensor using a spin transfer torque device according to the present invention is easily used for the development of disposable diagnostic kits because it has a low manufacturing cost. The magnetic sensor using a spin transfer torque device of the present invention can be applied to electronic compasses for mobile devices because it has a very small size and can ensure a high sensitivity characteristic, thereby providing a possibility for high marketability.

### Claims

**1.** A magnetic sensor using a spin transfer torque device, comprising:

a spin transfer torque device configured such that a magnetization direction thereof is varied by applied direct current (DC) power;
a bipolar pulse source configured to apply bipolar pulses to the spin transfer torque device in order to control a coercive field and sensitivity of the spin transfer torque device; and
a signal processing unit configured to calculate magnetic susceptibility or magnetic resistance by counting parallel (P) or anti-parallel (AP) states of the spin transfer torque device in response to the applied bipolar pulses.

**2.** The magnetic sensor of claim 1, wherein the signal processing unit comprises:

a counter configured to count the P or AP states of the spin transfer torque device; and
a computation unit configured to perform computation on values counted by the counter.

3. The magnetic sensor of claim 1, wherein a low frequency band-pass filter is added upstream of the signal processing unit in order to eliminate high frequency components attributable to the bipolar pulses.

4. The magnetic sensor of any one of claims 1 to 3, further comprising a bias unit configured to apply an offset bias to the spin transfer torque device in order to control a location of a dynamic range of the spin transfer torque device.

5. The magnetic sensor of any one of claims 1 to 3, further comprising a resistor unit of a resistance characteristic connected in series to the spin transfer torque device, wherein an output level of the magnetic sensor is adjusted by controlling a resistance value of the resistor unit.

6. The magnetic sensor of claim 5, wherein the output level of the magnetic sensor is adjusted by a second spin transfer torque device connected in series to the spin transfer torque device.

7. A magnetic sensor using a spin transfer torque device, comprising:

a spin transfer torque device configured such that a magnetization direction thereof is varied by applied DC power;
a bipolar pulse source configured to apply bipolar pulses to the spin transfer torque device in order to control a coercive field and sensitivity of the spin transfer torque device; and
a low frequency band-pass filter configured to extract an average value of fluctuating magnetic resistance of the spin transfer torque device.

8. An integrated circuit chip of a spin transfer torque-type magnetic sensor, comprising:

a spin transfer torque device configured such that a magnetization direction thereof is varied by applied DC power;
an offset control unit configured to control an offset of output of the spin transfer torque device; and
electrode pads configured to receive and output signals from and to the spin transfer torque device;
wherein the spin transfer torque device, the offset control unit, and the electrode pads are integrated into a single substrate.

9. The integrated circuit chip of a spin transfer torque-type magnetic sensor of claim 8, further comprising:

a coercive field/dynamic range control unit configured to control a coercive field and sensitivity of the spin transfer torque device; and
a signal processing unit configured to calculate magnetic susceptibility or magnetic resistance by counting P or AP states of the spin transfer torque device in response to the applied bipolar pulses.

10. The integrated circuit chip of a spin transfer torque-type magnetic sensor of claim 9, comprising a low frequency band-pass filter configured to extract an average of the magnetic susceptibility of the spin transfer torque device, instead of the signal processing unit.

11. The integrated circuit chip of a spin transfer torque-type magnetic sensor of claim 8, further comprising an analog-to-digital converter (ADC) configured to convert analog signals of the sensor into digital signals.

12. A disposable magnetic sensor using a spin transfer torque device, wherein the disposable magnetic sensor uses the integrated circuit chip of claim 8.

13. A method, comprising connecting the disposable magnetic sensor of claim 12 to a port of a mobile communication terminal, running a magnetic field measurement application of the mobile communication terminal, and measuring a magnetic field applied to the magnetic sensor.

14. A nondestructive test sensor for detecting micro-cracks, wherein the nondestructive test sensor uses the integrated circuit chip of a spin transfer torque-type magnetic sensor of any one of claims 7 to 10.

15. A medical nanoparticle sensor, wherein the medical nanoparticle sensor uses the integrated circuit chip of a spin transfer torque-type magnetic sensor of any one of claims 8 to 11.

FIG. 1

FIG. 2

# FIG. 3

# FIG. 4

# FIG. 5

(a)            (b)

# FIG. 6

signal processing unit

$ctrl1 \rightarrow$ **bipolar pulse source** (1) $\rightarrow$ **spin transfer torque device** (2) $\rightarrow$ **counter** (3) $\rightarrow$ $m_s$, $n_s$ $\rightarrow$ **computation unit** (4) $\rightarrow$ V_out

## FIG. 7

(a) I

Offset

t

(b) R

$(m/t_c)\tau_{AP}$   $(2m/t_c)\tau_{AP}$

$(n/t_c)\tau_P$   $(0n/t_c)\tau_{AP}$

t

H>0   $m_s>n_s$

(c) R

t

H=0   $m_s=n_s$

(d) R

$\tau_{AP}$

$\tau_P$

t

H<0   $m_s<n_s$

## FIG. 8

1    2    5

| bipolar pulse source | spin transfer torque device | low frequency band-pass filter |

ctrl1 →

V_out →

7

6

ctrl2 → bias unit

## FIG. 9

No Bias input

$R_{AVG}$

$R_H$

$R_L$

H

(a)

+V Bias

$R_{AVG}$

$R_H$

$R_L$

H

(b)

-V Bias

$R_{AVG}$

$R_H$

$R_L$

H

(c)

# FIG. 10

# FIG. 11

FIG. 12

13

ADC

Digital out

12

OCC

Analog out

SD 10

Control signal

CDCC 11

9

silicon substrate

FIG. 13

15

SD

OCC 16

Electric contact pads

silicon substrate

17

14

Control signal

Analog out

Field data output

19

20

FIG. 14

21

Field data
read out

## INTERNATIONAL SEARCH REPORT

| | International application No. |
|---|---|
| | **PCT/KR2012/009720** |

**A. CLASSIFICATION OF SUBJECT MATTER**

***G01R 33/02(2006.01)i***

According to International Patent Classification (IPC) or to both national classification and IPC

**B. FIELDS SEARCHED**

Minimum documentation searched (classification system followed by classification symbols)
G01R 33/02; H01L 43/08; G11B 5/39; G11C 11/15; G01R 33/09; G01R 15/20; H04B 1/40

Documentation searched other than minimum documentation to the extent that such documents are included in the fields searched
Korean Utility models and applications for Utility models: IPC as above
Japanese Utility models and applications for Utility models: IPC as above

Electronic data base consulted during the international search (name of data base and, where practicable, search terms used)
eKOMPASS (KIPO internal) & Keywords: magnetic sensor, spin torque element, pulse, offset bias

**C. DOCUMENTS CONSIDERED TO BE RELEVANT**

| Category* | Citation of document, with indication, where appropriate, of the relevant passages | Relevant to claim No. |
|---|---|---|
| X | WO 2011-013412 A1 (FUJI ELECTRIC HOLDINGS CO., LTD.) 03 February 2011 See abstract, paragraphs [0024]-[0033], claims 1-4 and figure 1. | 1-3,5-6 |
| A | | 4,7-15 |
| A | KR 10-2005-0108051 A (KIM, Jin Eog) 16 November 2005 See abstract, pages 3-4, claims 1,9 and figure 3. | 1-15 |
| A | KR 10-2004-0081200 A (HONEYWELL INTERNATIONAL INC.) 20 September 2004 See abstract, pages 3-4, claims 1-12 and figure 1. | 1-15 |
| A | KR 10-2009-0007201 A (KABUSHIKI KAISHA HITACHI SEISAKUSHO(D/B/A HITACHI, LTD.) et al.) 16 January 2009 See abstract, paragraphs [0109]-[0114], claims 1-2,6 and 18-20 and figures 1,8a-9. | 1-15 |
| A | JP 2011-185870 A (TDK CORPORATION) 22 September 2011 See abstract, claim 1 and figure 1. | 1-15 |

☐ Further documents are listed in the continuation of Box C.   ☒ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 23 MAY 2013 (23.05.2013) | **29 MAY 2013 (29.05.2013)** |

| Name and mailing address of the ISA/KR | Authorized officer |
|---|---|
| Korean Intellectual Property Office Government Complex-Daejeon, 189 Seonsa-ro, Daejeon 302-701, Republic of Korea | |
| Facsimile No. 82-42-472-7140 | Telephone No. |

Form PCT/ISA/210 (second sheet) (July 2009)

International application No.

**PCT/KR2012/009720**

| Patent document cited in search report | Publication date | Patent family member | Publication date |
|---|---|---|---|
| WO 2011-013412 A1 | 03.02.2011 | EP 2461168 A1<br>KR 10-2012-0040221 A<br>US 2012-0187945 A1 | 06.06.2012<br>26.04.2012<br>26.07.2012 |
| KR 10-2005-0108051 A | 16.11.2005 | NONE | |
| KR 10-2004-0081200 A | 20.09.2004 | AU 2003-215132 A1<br>AU 2003-215132 A8<br>CA 2476243 A1<br>EP 1481256 A2<br>JP 2005-517937 A<br>US 2003-0151406 A1<br>US 6984978 B2<br>WO 03-069690 A2 | 04.09.2003<br>04.09.2003<br>21.08.2003<br>01.12.2004<br>16.06.2005<br>14.08.2003<br>10.01.2006<br>21.08.2003 |
| KR 10-2009-0007201 A | 16.01.2009 | CN 101345079 A<br>EP 2015307 A1<br>JP 2009-021586 A<br>US 2009-0016098 A1<br>US 8138758 B2 | 14.01.2009<br>14.01.2009<br>29.01.2009<br>15.01.2009<br>20.03.2012 |
| JP 2011-185870 A | 22.09.2011 | CN 102193072 A<br>EP 2367019 A1<br>JP 4936030 B2<br>US 2011-0221433 A1 | 21.09.2011<br>21.09.2011<br>23.05.2012<br>15.09.2011 |

Form PCT/ISA/210 (patent family annex) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• KR 0820079